# EUROPEAN PATENT APPLICATION

(11) **EP 2 302 731 A1**
(43) Date of publication of application: **30.03.2011**
(21) Application number: 10177162.4
(22) Date of filing: 16.09.2010
(51) Int. Cl.: H01P 1/212, H01P 1/203, H03F 3/60

(54) **Filter and amplifying circuit**

(30) Priority: 18.09.2009 JP 2009217547
(71) Applicant: Fujitsu Limited, Kawasaki-shi, Kanagawa 211-8588 (JP)
(72) Inventor: Honda, Hirotake, Kawasaki-shi Kanagawa 211-8588 (JP); Maeda, Hiroaki, Kawasaki-shi Kanagawa 211-8588 (JP); Okazaki, Yousuke, Kawasaki-shi Kanagawa 211-8588 (JP); Shizawa, Yoshinobu, Kawasaki-shi Kanagawa 211-8588 (JP)
(74) Representative: Fenlon, Christine Lesley

(57) **Abstract**

There is provided a filter (3) which includes a transmission line (10), a stub (20) branched from the transmission line, the stub electrically coupled with the transmission line, and a resonator (30) configured to electromagnetically couple with the stub and to resonate at an odd harmonic frequency of a fundamental wave, the fundamental wave propagating through the transmission line.

## Description

### FIELD

The embodiments discussed herein are related to a filter and an amplifying circuit for an electronic signal.

### BACKGROUND

One of filters for attenuating high frequency signals is a stub coupled to an output terminal of an amplifier. A short stub has an electrical length λ/*4* for a fundamental wavelength λ of output signal of an amplifier. The short stub may suppress a wave of even multiple of the fundamental frequency and allows the waves of the fundamental frequency and odd multiple of the fundamental frequency to pass through.

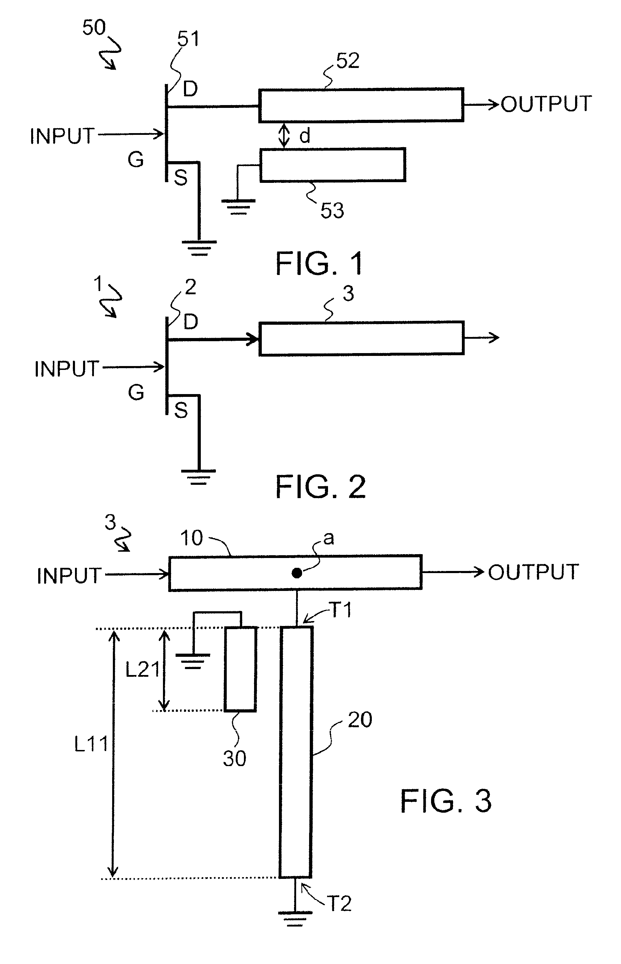

An example of a filter configuration is illustrated in FIG. 1 in which the filter may attenuate harmonics having integral multiple orders of the fundamental frequency. A resonator 53 is coupled to an amplifying circuit 50 so as to be parallel and apart by a certain distance dto a transmission line 52 which is coupled to an output portion of an amplifier 51 composed of a field effect transistor (FET). The resonator 53 has a length of λ*_{nf}*/*4* and is grounded at its one end, where λ*_{nf}* is a wavelength corresponding to a target harmonic *nf.* The resonator 53 resonates at the harmonic *nf*. Accordingly, the connection of the resonator 53 to the transmission line 52 causes the harmonic *nf* existing over the transmission line 52 to travel back to the amplifier 51 which is arranged at an input side of the transmission line 52. A related invention is, for example, disclosed in Japanese Laid-open Patent Publication No. 08-139535.

In Japanese Laid-open Patent Publication No. 05-199047, there is proposed a microwave semiconductor amplifier which includes input and output impedance matching circuits and a semiconductor such as a field effect transistor. The output impedance matching circuit includes a harmonic suppression circuit having a plurality of open end lines. The lines are connected in parallel and have respective lengths of one-fourth of the wavelengths of corresponding harmonics. The harmonic suppression circuit is used as an impedance matching element in the amplifier.

Japanese Laid-open Patent Publication No. H5-191175 discloses a microwave power amplifier. The amplifier comprises a power amplifying means, and a first and a second coupling line means. The power amplifying means amplifies a power of a high frequency signal by an amplifying element to output the high frequency power to an output terminal. Both ends of the first coupling line means are a first connection point as the output terminal and a second connection point, respectively, at which a high frequency signal is output. An electrical length between the first and the second connection points is a first electrical length. The second coupling line means has an electrical length same to the first electrical length, electro-magnetically couples with the first coupling line means each other, and operates so as to ground an output of the amplifying element where an electrical length of including an parasitic line between the amplifying element and the output terminal is corresponding to an electrical length by which an output of the amplifying element is virtually grounded for a second-order harmonic of a fundamental frequency of the high frequency signal amplified by the power amplifying means.

### SUMMARY

Accordingly, it is desirable to provide a filter for reducing the odd-order harmonics with suppressing the length of the transmission line.

According to an embodiment of an aspect of the invention, a filter comprises a transmission line, a stub branched from the transmission line, the stub electrically being coupled with the transmission line; and a resonator configured to electromagnetically couple with the stub and to resonate at an odd harmonic frequency of a fundamental wave, the fundamental wave propagating through the transmission line.

### BRIEF DESCRIPTION OF THE DRAWINGS

FIG. 1 is a diagram illustrating a configuration of an existing amplifier;

FIG. 2 is a diagram illustrating a configuration of an amplifying circuit according to an embodiment;

FIG. 3 is a first example of a filter in the amplifying circuit illustrated in FIG. 2;

FIG. 4 is a second example of the filter in the amplifying circuit illustrated in FIG. 2;

FIG. 5 is a third example of the filter in the amplifying circuit illustrated in FIG. 2;

FIG. 6 is a fourth example of the filter in the amplifying circuit illustrated in FIG. 2;

FIG. 7 is a fifth example of the filter in the amplifying circuit illustrated in FIG. 2;

FIG. 8 is a diagram illustrating a result obtained by a simulation on an attenuation characteristic of the filter illustrated in FIG. 5; and

FIG. 9 is a diagram illustrating a result obtained by a simulation on an attenuation characteristic of the filter illustrated in FIG. 6.

### DESCRIPTION OF EMBODIMENTS

The existing filter with the stub described in Background may not reduce the odd-order harmonics, while the existing filter illustrated FIG. 1 may be configured to reduce the odd-order harmonics. However, the existing filter illustrated in FIG. 1 needs a length of the transmission line 52 extended to some extent for sufficient electromagnetic coupling between the transmission line 52 and the resonator 53. Accordingly, the extended length of the transmission line 52 may result in an increase in intensity of signal propagating in the transmission line 52.

There will be described the embodiments according to the present invention with reference to figures. FIG. 2 illustrates a configuration diagram of an embodiment applied to an amplifying circuit. An amplifying circuits 1 includes an amplifier 2 and a filter 3 connected to an output terminal of the amplifier 2. The amplifier 2 is, for example, a field effect transistor (FET) of which source is grounded in the embodiment illustrated in FIG. 2. The drain common FET may be usable also. The amplifying circuit 1 may be a high frequency amplifying circuit such as a microwave amplifying circuit.

FIG. 3 illustrates a first example of a configuration of the filter 3 illustrated in FIG. 2. The filter 3 includes the transmission line, a stub 20 branched from the transmission line 10, and a resonator 30 electromagnetically coupled with the stub 20.

As described above, the resonator 30 is electromagnetically coupled with the stub and resonates at an odd harmonic of a fundamental frequency of the signal propagating though the transmission line 10. The resonator 30 may be a coupling line with a grounded and an open ends configured with a distributed parameter circuit. The resonator 30 is disposed parallel to and coupled electromagnetically to the stub 20. The electrical length L₂₁ of the resonator 30 may be λ*_{O}*/*4* where λ*_{O}* is the wavelength of the odd harmonic to be suppressed. When composing a filter for suppressing the third order harmonic of a fundamental wave having a wavelength λ, the electrical length L₂₁ of the resonator 30 is λ/*12*. The electrical length L₂₁ of the resonator 30 is λ/*20* for the filter 3 suppressing the fifth order harmonics

The electromagnetic coupling of the resonator 30 to the stub 20 results in that a connecting point "a" therebetween is grounded with respect to the odd harmonic to be reduced. Accordingly, the odd harmonic may be reflected back to the amplifier 2. Therefore, the odd harmonic in the output from the amplifying circuit 1 may be reduced.

In the present embodiment, the resonator 30 is electromagnetically coupled to not the transmission line 10 but the stub 20. Thus extending the transmission line 10 is not necessary for electromagnetically coupling with the resonator 30, unlike the existing filter illustrated in FIG. 1. The present embodiment provides a filter that suppresses the odd harmonics and includes a transmission line having a length shorter than that of the existing filter. Accordingly, the loss of signal intensity decreases in the present embodiment.

The stub 20 may be, for example, a short stub having an electrical length L₁₁ equivalent to λ/*4* with respect to a fundamental wave of a wave length λ propagating as a signal in the transmission line 10. The end T1 of the stub 20 is connected to the connecting point "a" of the transmission line 10 and the other end T2 of the stub 20 is grounded. Connecting the stub 20 to the transmission line 10 allows the connecting point "a" to be grounded with respect to an even harmonic of a fundamental wave and the even harmonic to be reflected back to the amplifier 2 from the connecting point 2. Accordingly, the even harmonic in the signal output from the amplifying circuit 1 is suppressed, while the fundamental wave propagates though the portion of the connecting point "a".

The filter 3 reduces the even harmonic and any odd harmonic even by using the short stub, as the stub 20, having the electrical length λ / *4* with respect to the fundamental wave having a wavelength λ. Further, the use of the short stub decreases also a harmful effect on the filter 3.

The resonator 30 may be disposed at a portion near the end T1 connected to the transmission line 10. The intensity of the signal propagating through the stub 20 is stronger at the end TI than that at the other end T2. Thus disposing the resonator 30 near the end T1 increases the effect of suppressing the odd harmonic desired to be reduced.

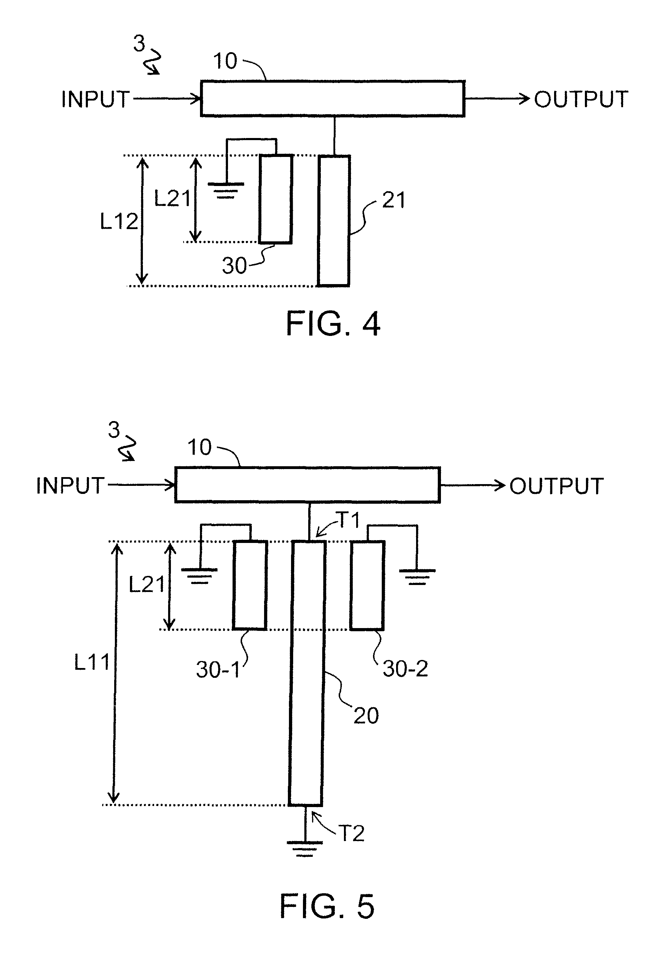

The second example of configuration of the filter 3 is explained with reference to FIG. 4. The filter 3 includes a stub 21 branched from the transmission line 10, the resonator 30 electromagnetically coupled with the stub 21. The resonator 30 may be provided in a same way as the resonator 30 described above with reference to FIG. 3.

The stub 21 may be an open stub having an electrical length L12 of λ/*8* with respect to a wavelength λ of a fundamental wave. The stub 21 is electrically coupled with the transmission line 10 through an end T1 of the both ends of the stub 21 and the other end T2 is opened.

The filter 3 of the second example may suppress also an even harmonic and any odd harmonic and decreases harmful effect on the fundamental wave. Further the stub 21 provided in a form of an open stub has an advantage of easy adjustment of its electrical length. In any embodiment described later, the stub branching from the transmission line 10 may be any one of the short stub or the open stub.

The other example of the filter 3 will be explained with reference to FIG. 5 which illustrates the third example of the detail configuration of the filter 3 depicted in FIG. 2. Resonators 30-1 and 30-2 have each configuration same to the resonator 30 illustrated in FIG. 3. The filter 3 of the present example includes a stub 20 branched from the transmission line 10, and the resonators 30-1 and 30-2 electromagnetically coupled with the stub 20.

The resonators 30-1 and 30-2 are disposed on the both sides of the stub 20, that is, the resonators 30-1 and 30-2 are arranged parallel to the stub 20 so as to allow the stub 20 to position between the resonators 30-1 and 30-2. Electromagnetic coupling provided by the configuration of the resonators 30-1 and 30-2 and the stub 20 therebetween performs the suppression of the odd harmonic as a target more efficiently than that performed by electromagnetic coupling with a single resonator and a stub.

The resonators 30-1 and 30-2 may be disposed at a portion near to the end T1, of both ends of the stub 20, through which the stub 20 and the transmission line 10 are connected each other. Further, the number of resonators provided at each side of the stub 20 is not limited to one. That is, a plurality of resonators may be disposed on the both sides of the stub 20.

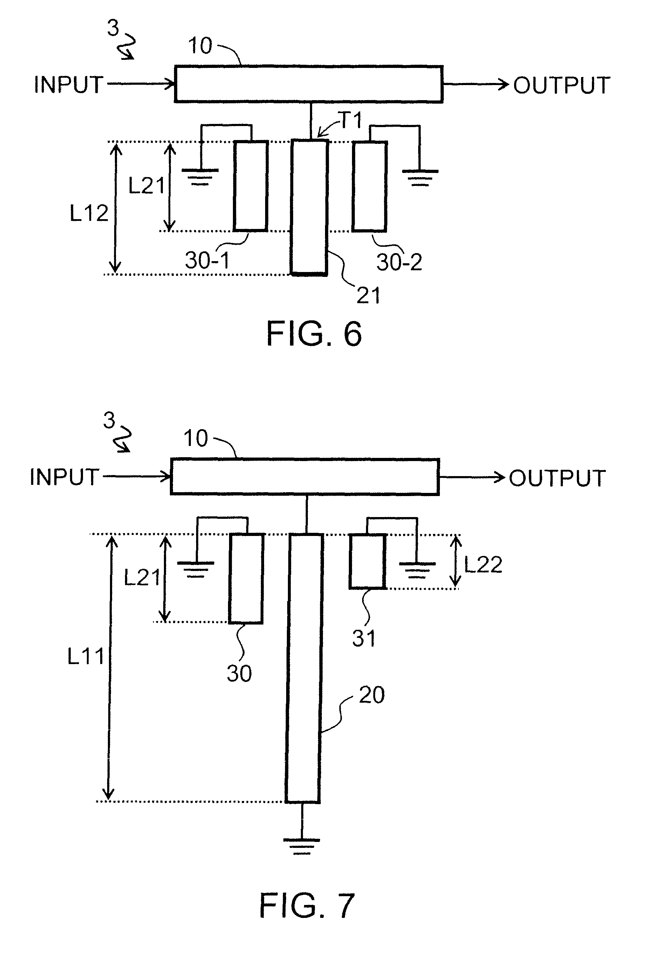

FIG. 6 illustrates the fourth embodiment of the filter 4 depicted in FIG. 2. The filter 3 of the present embodiment includes an open stub 21 branched from the transmission line 10 and resonators 30-1 and 30-2 each of which is disposed at each of the both sides of the open stub 21 respectively. Electromagnetic coupling provided by the configuration of the resonators 30-1 and 30-2 and the open stub 21 therebetween performs the suppression of the odd harmonic as a target more efficiently than that performed by electromagnetic coupling with a single resonator and a stub.

The other example of the filter 3 will be explained with reference to FIG. 7 which illustrates the fifth example of the detail configuration of the filter 3 depicted in FIG. 2. Resonator 31 includes a configuration same to the resonator 30 illustrated in FIG. 3. The filter 3 of the present example includes a stub 20 branched from the transmission line 10, and the resonators 30 and 31 electromagnetically coupled with the stub 20.

The resonators 30 and 31 are formed to have respective different resonant frequencies, for example, the resonant frequencies of the resonators 30 and 31 may be the third harmonic and the fifth harmonic of the fundamental wave respectively.

As a detail example, the resonators 30 and 31 are coupling lines provided as coupling lines represented by respective distributed parameter circuits each having open and grounded ends. Supposing that the wavelengths of the third and fifth harmonics are λ*ₜₕ* and λ*_{f}*, then the electrical length L21 of the resonator 30 may be λ*ₜₕ*/*4* and the electrical length L22 of the resonator 31 λ*_{f}*/*4*.

The fifth example as the embodiment provides a filter that suppresses a plurality of even harmonics at a same time.

The fifth example may be configured so that the resonators 30 and 31 are disposed parallel to and on the both sides of the stub 20 so as to position the stub 20 between the resonators 30 and 31 as illustrated in FIG. 7.

Further the resonators 30 and 31 may be disposed at a portion near to the end T1, of both ends of the stub 20, through which the stub 20 and the transmission line 10 are connected each other. Further, the number of resonant frequencies is not limited to two. That is, the filter 30 may include threes or more resonators which are electromagnetically coupled with the stub 20 to provide three or more resonant frequencies. Further, the filter 3 may be an open stub instead of the filter 30 as a short stub.

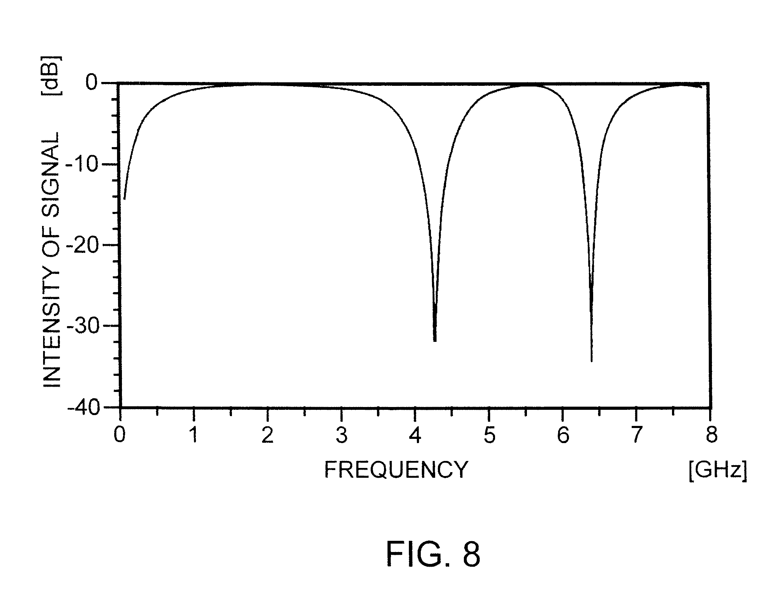

FIG. 8 is a diagram illustrating a graph obtained by a simulation to illustrate a result of an attenuation characteristic of the filter 3 illustrated in FIG. 5. The simulation was performed for a filter designed for attenuating or suppressing the second and the third harmonics of a RF or high frequency signal of 2.1 GHz band. The stub 20 was a short stub having an electrical length λ/*4* of the fundamental wave having a wavelength λ. The abscissa axis represents the frequency of a signal input to the filter and the vertical axis represents the intensity of signal passing through the filter.

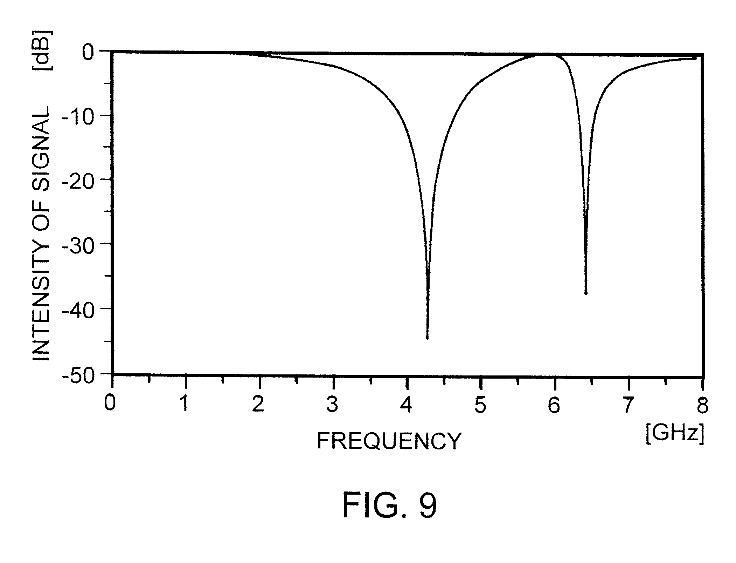

FIG. 9 is a diagram illustrating a graph obtained by a simulation to illustrate a result of an attenuation characteristic of the filter 3 illustrated in FIG. 6. The simulation was performed for a filter designed for attenuating or suppressing the second and the third harmonics of a RF or high frequency signal of 2.1 GHz band. The stub 21 was an open stub having an electrical length λ/*8* of the fundamental wave having a wavelength λ. In FIG. 9, the abscissa axis represents the frequency of a signal input to the filter and the vertical axis represents the intensity of signal passing through the filter.

FIGs. 8 and 9 illustrate the results that the filters according to the embodiments increase the attenuation around at frequencies 4.280 GHz and 6.420 GHz which are corresponding to the second harmonic and the third harmonic respectively. Accordingly, depending on the embodiments, there is provided the filter that may suppress an even harmonic and any odd harmonic and includes a shorter transmission line.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that the various changes, substitutions, and alterations could be made hereto without departing from the scope of the invention.

## Claims

1. A filter comprising:
a transmission line;
a stub branched from the transmission line, the stub electrically being coupled with the transmission line; and
a resonator configured to electromagnetically couple with the stub and to resonate at an odd harmonic frequency of a fundamental wave, the fundamental wave propagating through the transmission line.

2. The filter according to claim 1, wherein the stub is configured to suppress an even harmonic of the fundamental wave.

3. The filter according to claim 1 or 2, wherein the stub is configured with at least one of a short stub.

4. The filter according to any preceding claim, wherein the resonator is a coupled line disposed parallel to the stub, one of ends of the coupled line is grounded, and the other of the ends is open.

5. The filter according to claim 4, wherein the resonators are disposed on the both sides of the stub.

6. The filter according to claim 4 or 5, wherein the resonator is disposed at a portion near to an end of both ends of the stub, the stub being electrically coupled through the end.

7. The filter according to any preceding claim, wherein a plurality of the resonators resonate at respective different odd harmonic frequencies.

8. An amplifying circuit comprising:
an amplifier;
a transmission line configured to transmit an output of the amplifier; and
**characterized in that** the amplifier circuit has the filter according to clams 1 to 7.
